# EUROPEAN PATENT APPLICATION

(11) **EP 4 765 477 A1**
(43) Date of publication of application: **24.06.2026**
(21) Application number: 26158153.2
(22) Date of filing: 16.05.2025
(51) Int. Cl.: H01Q 1/22, H10W 40/10

(54) **INTEGRATED ANTENNA DEVICE AND MANUFACTURING METHOD THEREOF**

(30) Priority: 16.12.2024 TW 113149017; 25.04.2025 TW 114115663
(62) Divisional of application: 25176948.5
(71) Applicant: TMY Technology Inc., New Taipei City 220056 (TW)
(72) Inventor: CHANG, Su-Wei, 220056 New Taipei City (TW); WU, Chih-Hsien, 220056 New Taipei City (TW); HSU, Shao-Chun, 220056 New Taipei City (TW); WU, Po-Hsuan, 220056 New Taipei City (TW); HSU, Che Wei, 220056 New Taipei City (TW)
(74) Representative: Becker, Eberhard

(57) **Abstract**

A method (200, 200a, 300) of manufacturing an integrated antenna device (100, 100a, 100b) includes: a circuit board assembly is provided; the circuit board assembly includes a substrate (110) and at least one antenna (120); an at least one radio-frequency integrated circuit module (189) is positioned to the second surface (114) of the substrate (110), each of the radio-frequency integrated circuit modules (189) includes a radio-frequency integrated circuit (130) and a heat conducting structure (160, 160b); at least one set of metal pillars (140) is positioned to the second surface (114); an encapsulant is disposed on the second surface (114), and solidified into an encapsulation (150, 152) to encapsulate each of the radio-frequency integrated circuit modules (189) and the metal pillars (140); and the encapsulation (150, 152) is polished until each of the heat conducting structures (160, 160b) and the second ends (144) are exposed from the encapsulation (150, 152).

## Description

### BACKGROUND

### Technical Field

The disclosure relates to an integrated antenna device and a manufacturing method thereof, and in particular to an integrated antenna device which has good heat dissipation performance and a manufacturing method thereof.

### Related Art

In the current antenna module architecture, the farther the distance between the radio-frequency integrated circuit and the antenna, the more severe the signal loss caused by the intermediate electromagnetic path. Moreover, the longer the signal lines between the radio-frequency integrated circuit and the antenna, the more severe the near end crosstalk (NEXT) and far end crosstalk (FEXT) interference become. To solve such problems, one solution is to integrate the radio-frequency integrated circuit and the antenna together. However, since the radio-frequency integrated circuit and the antenna generate high heat during operation, how to improve heat dissipation performance is a research direction in the art.

### SUMMARY

The disclosure provides an integrated antenna device, which has good heat dissipation performance.

An integrated antenna device of the disclosure includes a substrate, at least one antenna, a radio-frequency integrated circuit, multiple metal pillars, an encapsulation, and a heat conducting structure. The substrate includes a first surface and a second surface opposite to each other. At least one antenna is disposed on the first surface. The radio-frequency integrated circuit (RFIC) is disposed on the second surface. The radio-frequency integrated circuit includes a third surface and a fourth surface opposite to each other. The third surface is facing the second surface. The metal pillars respectively include multiple first ends and multiple second ends opposite to each other. The first ends are disposed on the second surface. The metal pillars surround the radio-frequency integrated circuit. The encapsulation is disposed on the second surface, encapsulating at least a portion of the radio-frequency integrated circuit and at least a portion of each of the metal pillars. The heat conducting structure is disposed above the fourth surface and thermally coupled to the radio-frequency integrated circuit. An outer surface of the heat conducting structure is flush with the second ends of the metal pillars. The outer surface and the second ends are exposed from the encapsulation.

In an embodiment of the disclosure, the encapsulation exposes another portion of the radio-frequency integrated circuit and another portion of each of the metal pillars.

In an embodiment of the disclosure, the encapsulation encapsulates the entire radio-frequency integrated circuit, and encapsulates a part of the metal pillars other than the second ends.

In an embodiment of the disclosure, the integrated antenna device further includes a heat interposer, which is positioned between the heat conducting structure and the radio-frequency integrated circuit and respectively connected to the heat conducting structure and the radio-frequency integrated circuit.

In an embodiment of the disclosure, the heat interposer includes a conductive material.

In an embodiment of the disclosure, a thickness of the heat interposer is less than 20 microns.

In an embodiment of the disclosure, a thermal conductivity of a material of the heat conducting structure is greater than or equal to 200W/m-K.

In an embodiment of the disclosure, the heat conducting structure is a heat conducting plate.

In an embodiment of the disclosure, the heat conducting structure includes multiple heat conducting pillars separating from each other. The heat conducting pillars are encapsulated by another encapsulation.

A method of manufacturing an integrated antenna device of the disclosure includes: a circuit board assembly is provided, and the circuit board assembly includes a substrate, at least one antenna and at least one radio-frequency integrated circuit, the substrate includes a first surface and a second surface opposite to each other, the at least one antenna is disposed on the first surface, the radio-frequency integrated circuit is disposed on the second surface, each of the radio-frequency integrated circuits includes a third surface and a fourth surface opposite to each other, and the third surface is facing the second surface; at least one set of metal pillars is positioned to the second surface of the substrate, and each set of the metal pillars includes multiple metal pillars, the metal pillars surround the corresponding radio-frequency integrated circuit, the metal pillars respectively include multiple first ends and multiple second ends opposite to each other, and the first ends are disposed on the second surface; an encapsulant is disposed on the second surface of the substrate, and solidified into an encapsulation to encapsulate at least a portion of each of the radio-frequency integrated circuits and at least a portion of each of the metal pillars; and at least one heat conducting structure is disposed on the at least one radio-frequency integrated circuit, and each of the heat conducting structures is disposed above the fourth surface of the corresponding radio-frequency integrated circuit, and each of the heat conducting structures is thermally coupled to the corresponding radio-frequency integrated circuit.

In an embodiment of the disclosure, the at least one antenna includes multiple antennas, the at least one radio-frequency integrated circuit includes multiple radio-frequency integrated circuits, the at least one set of metal pillars includes multiple sets of metal pillars, the at least one heat conducting structure includes multiple heat conducting structures, the substrate is divided into multiple sub-regions arranged in an array, the sub-regions are spaced apart by multiple precut lines, the antennas, the radio-frequency integrated circuits, the sets of metal pillars, the heat conducting structures are respectively disposed in the sub-regions, and the manufacturing method further includes: the encapsulation and the circuit board assembly is cut along the precut lines to obtain multiple integrated antenna devices, and an outer surface of the heat conducting structure of each of the integrated antenna devices is exposed from the corresponding encapsulation, and the outer surface is flush with the second ends of the corresponding metal pillars.

In an embodiment of the disclosure, in the step of positioning each set of the metal pillars to the second surface of the substrate, the manufacturing method further includes: a hot-melt adhesive is covered on the second ends of the metal pillars in each set of the metal pillars to position the metal pillars.

In an embodiment of the disclosure, after the step of solidifying the encapsulant into an encapsulation, the manufacturing method further includes: the hot-melt adhesive is removed by heating to expose the second ends.

In an embodiment of the disclosure, before the step of disposing each of the heat conducting structures on the fourth surface of the corresponding radio-frequency integrated circuit, the manufacturing method further includes: at least one heat interposer is disposed on the at least one radio-frequency integrated circuit, and each of the heat interposers is disposed on the fourth surface of the corresponding radio-frequency integrated circuit, and each of the heat conducting structures is disposed on the corresponding heat interposer to be thermally coupled to the corresponding radio-frequency integrated circuit in the step of disposing each of the heat conducting structures on the fourth surface of the corresponding radio-frequency integrated circuit.

In an embodiment of the disclosure, after the step of disposing each of the heat conducting structures on the fourth surface of the corresponding radio-frequency integrated circuit, an outer surface of each of the heat conducting structures is exposed from the encapsulation, and the outer surface is flush with the second ends of the corresponding metal pillars.

In an embodiment of the disclosure, the step of disposing each of the heat conducting structures on the fourth surface of the corresponding radio-frequency integrated circuit and allowing the heat conducting structure to be thermally coupled to the radio-frequency integrated circuit is performed before the step of positioning each set of the metal pillars to the second surface of the substrate.

In an embodiment of the disclosure, before the step of disposing each of the heat conducting structures on the fourth surface of the corresponding radio-frequency integrated circuit, the manufacturing method further includes: at least one heat interposer is disposed on the at least one radio-frequency integrated circuit, and each of the heat interposers is disposed on the fourth surface of the corresponding radio-frequency integrated circuit, and each of the heat conducting structures is disposed on the corresponding heat interposer to be thermally coupled to the corresponding radio-frequency integrated circuit in the step of disposing each of the heat conducting structures on the fourth surface of the corresponding radio-frequency integrated circuit.

In an embodiment of the disclosure, in the step of solidifying the encapsulant into the encapsulation, the encapsulant clads each set of the metal pillars, the corresponding radio-frequency integrated circuit and the heat conducting structure. A height of each set of the metal pillars protruding from the second surface is greater than a height of the heat conducting structure relative to the second surface.

In an embodiment of the disclosure, after the step of solidifying the encapsulant into the encapsulation, the manufacturing method further includes: the encapsulation is polished until an outer surface of each of the heat conducting structures is exposed from the encapsulation, and the outer surface is flush with the second ends of the corresponding metal pillars.

A method of manufacturing an integrated antenna device of the disclosure includes: a circuit board assembly is provided; the circuit board assembly includes a substrate and at least one antenna, the substrate includes a first surface and a second surface opposite to each other, and the at least one antenna is disposed on the first surface; an at least one radio-frequency integrated circuit module is positioned to the second surface of the substrate; each of the radio-frequency integrated circuit modules includes a radio-frequency integrated circuit and a heat conducting structure, the radio-frequency integrated circuit includes a third surface and a fourth surface opposite to each other, the third surface is facing the second surface, and the heat conducting structure is disposed above the fourth surface and thermally coupled to the radio-frequency integrated circuit; at least one set of metal pillars is positioned to the second surface of the substrate; each set of the metal pillars includes multiple metal pillars, the metal pillars surround the corresponding radio-frequency integrated circuit module, the metal pillars respectively include multiple first ends and multiple second ends opposite to each other, and the first ends are disposed on the second surface; an encapsulant is disposed on the second surface of the substrate, and solidified into an encapsulation to encapsulate each of the radio-frequency integrated circuit modules and the metal pillars; and the heat conducting structure and the second ends of the metal pillars are allowed to be exposed from the encapsulation.

In an embodiment of the disclosure, before the step of positioning the at least one radio-frequency integrated circuit module to the second surface of the substrate, the method further includes: a first vehicle having a first adhesive layer is provided, and a first guide structure is disposed above the first vehicle, and the first guide structure includes multiple first perforations; multiple heat conducting pillars are allowed to extend into the first perforations of the first guide structure, and multiple third ends of the heat conducting pillars are allowed to contact the first adhesive layer and be fixed on the first vehicle; another encapsulant is disposed on the first vehicle, and solidified into another encapsulation to encapsulate the heat conducting pillars; the third ends of the heat conducting pillars that are encapsulated by the other encapsulation and multiple fourth ends opposite to the third ends are allowed to be exposed; and the third ends or the fourth ends exposed from the other encapsulation are allowed to be disposed above the fourth surface of the radio-frequency integrated circuit and thermally coupled to the radio-frequency integrated circuit.

In an embodiment of the disclosure, before the step of positioning the at least one set of metal pillars to the second surface of the substrate, the method further includes: a mask fixed on a second adhesive layer is provided, and a second guide structure is disposed above the mask; the mask includes multiple second perforations, the second guide structure includes multiple third perforations, and the third perforations are positioned to the second perforations; the metal pillars are allowed to extend into the third perforations of the second guide structure and the second perforations of the mask, and the first ends of the metal pillars are fixed on the second adhesive layer; the metal pillars are moved next to a second vehicle having a third adhesive layer, the second ends of the metal pillars are allowed to contact the third adhesive layer to allow the metal pillars to be fixed on the second vehicle; and the second adhesive layer is separated from the metal pillars, and the metal pillars fixed on the second vehicle are allowed to expose the first ends.

In an embodiment of the disclosure, after the step of separating the second adhesive layer from the metal pillars, the method further includes: the heat conducting structure of the radio-frequency integrated circuit module is fixed on the second vehicle, and the heat conducting structure is allowed to be positioned between the radio-frequency integrated circuit and the second vehicle, the radio-frequency integrated circuit module is surrounded by the metal pillars, and the third surface of the radio-frequency integrated circuit is flush with the first ends of the metal pillars.

In an embodiment of the disclosure, after the step of allowing the third ends or the fourth ends of the heat conducting pillars to be disposed above the fourth surface of the radio-frequency integrated circuit, and before the step of positioning the radio-frequency integrated circuit module to the second surface of the substrate, the method further includes: the heat conducting structure of each of the radio-frequency integrated circuit modules is fixed on a third vehicle having a fourth adhesive layer, and the heat conducting structure is allowed to be positioned between the radio-frequency integrated circuit and the third vehicle.

In an embodiment of the disclosure, the step of positioning the at least one radio-frequency integrated circuit module to the second surface of the substrate and the step of positioning the at least one set of metal pillars to the second surface of the substrate are executed at a same time.

In an embodiment of the disclosure, the step of allowing the heat conducting structure and the first ends of the metal pillars to be exposed from the encapsulation further includes: the encapsulation is polished until each of the heat conducting structures and the second ends of the corresponding metal pillars are exposed from the encapsulation, and a surface exposed by each of the heat conducting structures is flush with the second ends of the corresponding metal pillars.

Based on the above, according to the integrated antenna device of the disclosure, the antenna is disposed on the first surface of the substrate. The radio-frequency integrated circuit is disposed on the second surface of the substrate. This design may allow the antenna and the radio-frequency integrated circuit to be integrated together. In addition, the first ends of the metal pillars are disposed on the second surface of the substrate. The metal pillars surround the radio-frequency integrated circuit. The encapsulation is disposed on the second surface of the substrate, encapsulating at least a portion of the radio-frequency integrated circuit and at least a portion of each of the metal pillars to fix the metal pillars. The heat conducting structure is disposed above the fourth surface and thermally coupled to the radio-frequency integrated circuit. The outer surface of the heat conducting structure is flush with the second ends of the metal pillars. The outer surface of the heat conducting structure and the second ends of the metal pillars are flush with and exposed from the encapsulation. Therefore, the heat generated by the substrate and the radio-frequency integrated circuit may be transmitted to the outside through the metal pillars and the heat conducting structure, thereby achieving a good heat dissipation effect.

### BRIEF DESCRIPTION OF THE DRAWINGS

FIG. 1A to FIG. 1B are perspective views of an integrated antenna device from different viewing angles according to an embodiment of the disclosure.
FIG. 1C is a schematic cross-sectional view of FIG. 1A.
FIG. 2 is a schematic cross-sectional view of an integrated antenna device according to another embodiment of the disclosure.
FIG. 3 is a schematic flow chart of a method of manufacturing an integrated antenna device according to an embodiment of the disclosure.
FIG. 4A to FIG. 4G are schematic views of a process of manufacturing the integrated antenna device in FIG. 1C.
FIG. 5 is a schematic flow chart of a method of manufacturing an integrated antenna device according to another embodiment of the disclosure.
FIG. 6A to FIG. 6G are schematic views of a process of manufacturing the integrated antenna device in FIG. 2.
FIG. 7 is a schematic cross-sectional view of an integrated antenna device according to another embodiment of the disclosure.
FIG. 8A to FIG. 8I are schematic views of a process of manufacturing the radio frequency integrated circuit module of the integrated antenna device in FIG. 7.
FIG. 9A to FIG. 9E are schematic views of a process of positioning the metal pillars of the integrated antenna device in FIG. 7.
FIG. 10A to FIG. 10F are schematic views of a process of manufacturing the integrated antenna device in FIG. 7.
FIG. 11 is a schematic view of another embodiment of FIG. 10A.
FIG. 12 is a schematic flow chart of a method of manufacturing an integrated antenna device according to another embodiment of the disclosure.

### DESCRIPTION OF THE EMBODIMENTS

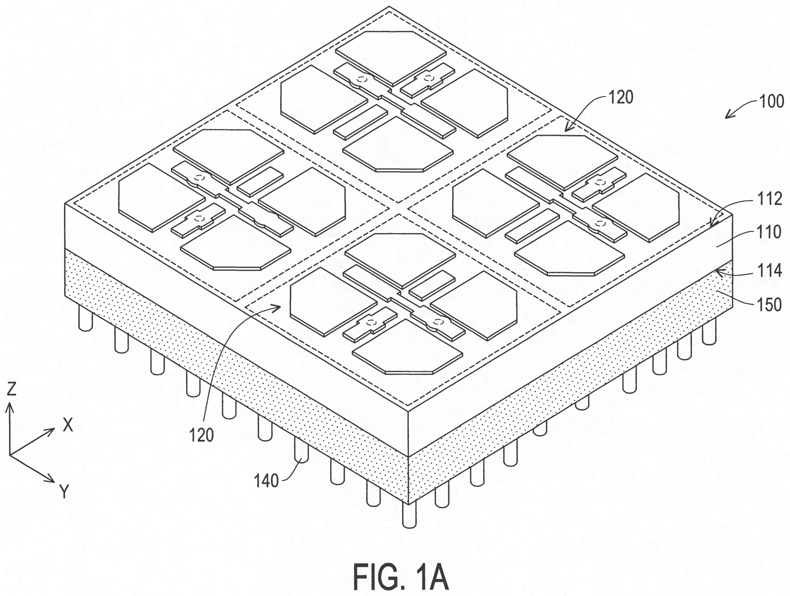

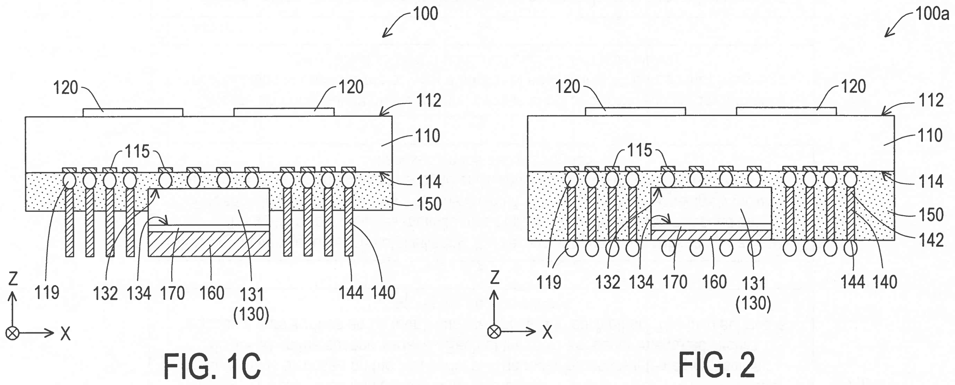

FIG. 1A to FIG. 1B are perspective views of an integrated antenna device from different viewing angles according to an embodiment of the disclosure. FIG. 1C is a schematic cross-sectional view of FIG. 1A. It should be noted that FIG. 1C is a simplified schematic view of FIG. 1A, where proportional relationships between elements are slightly different, and is only provided for illustrative purposes.

Please refer to FIG. 1A to FIG. 1C. An integrated antenna device 100 of the embodiment includes a substrate 110, at least one antenna 120, a radio-frequency integrated circuit 130, multiple metal pillars 140, an encapsulation 150, and a heat conducting structure 160.

The substrate 110 includes a first surface 112 and a second surface 114 opposite to each other. The at least one antenna 120 is disposed on the first surface 112. In the embodiment, a quantity of the antenna 120 is four, but the disclosure is not limited thereto. The radio-frequency integrated circuit 130 (RFIC) is disposed on the second surface 114. Therefore, the antenna 120 and the radio-frequency integrated circuit 130 are integrated on the same substrate 110, which may effectively reduce the probability of signal loss and crosstalk interference.

The metal pillars 140 respectively include multiple first ends 142 and multiple second ends 144 opposite to each other. The first ends 142 are disposed on the second surface 114. The metal pillars 140 surround the radio-frequency integrated circuit 130. In the embodiment, the radio-frequency integrated circuit 130 and the metal pillars 140 are respectively connected to the second surface 114 of the substrate 110 through solder balls 119, but the method of the radio-frequency integrated circuit 130 and the metal pillars 140 being connected to the second surface 114 of the substrate 110 is not limited thereto. In addition, a material of the metal pillars 140 is, for example, copper, but the material of the metal pillars 140 is not limited thereto.

It is worth mentioning that in the embodiment, a radio frequency circuit (not shown) is included inside the substrate. The second surface 114 of the substrate 110 has multiple electrical contacts 115 electrically connected to the radio frequency circuit. A portion of the electrical contacts 115 may allow the radio-frequency integrated circuit 130 to be coupled to the antenna 120 through the radio frequency circuit inside the substrate 110. Another portion of the electrical contacts 115 may allow a portion of the metal pillars 140 to be electrically connected to the radio-frequency integrated circuit 130. There is also a portion of the electrical contacts 115 that may allow certain metal pillars 140 to be coupled to the antenna 120.

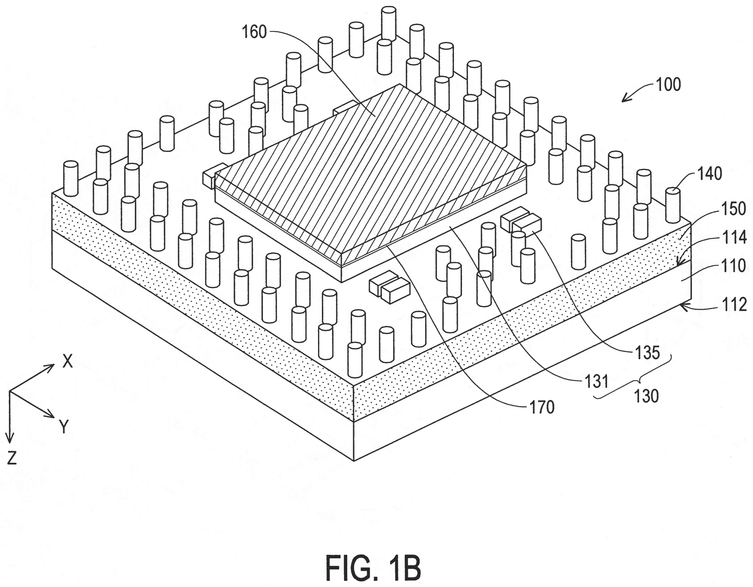

In addition, as shown in FIG. 1B, in the embodiment, the radio-frequency integrated circuit 130 includes a beamforming IC 131 (BFIC) and a power amplifier 135 (PA), but the composition of the radio-frequency integrated circuit 130 is not limited thereto. As shown in FIG. 1C, the beamforming IC 131 of the radio-frequency integrated circuit 130 includes a third surface 132 and a fourth surface 134 opposite to each other. The third surface 132 is facing the second surface 114.

The encapsulation 150 is disposed on the second surface 114 of the substrate 110, encapsulating at least a portion of the radio-frequency integrated circuit 130 and at least a portion of each of the metal pillars 140 to better fix the radio-frequency integrated circuit 130 and the metal pillars 140.

In the embodiment, the encapsulation 150 exposes another portion of the radio-frequency integrated circuit 130 and another portion of each of the metal pillars 140. This may allow the radio-frequency integrated circuit 130 and the metal pillars 140 to be partially exposed, which may enhance a heat dissipation effect. Certainly, a range where the encapsulation 150 encapsulates is not limited thereto.

The heat conducting structure 160 is disposed above the fourth surface 134 and thermally coupled to the radio-frequency integrated circuit 130. In the embodiment, the heat conducting structure 160 is a heat conducting plate, but the type of the heat conducting structure 160 is not limited thereto. In the embodiment, the integrated antenna device 100 further includes a heat interposer 170, which is positioned between the heat conducting structure 160 and the radio-frequency integrated circuit 130, and respectively connected to the heat conducting structure 160 and the radio-frequency integrated circuit 130 to allow the heat conducting structure 160 to be thermally coupled to the radio-frequency integrated circuit 130. Specifically, the heat interposer 170 is configured to allow the beamforming IC 131 of the radio-frequency integrated circuit 130 to be tightly fixed with the heat conducting structure 160. In this way, the heat generated by the beamforming IC 131 may be well transmitted to the heat conducting structure 160 through the heat interposer 170.

A thermal conductivity of a material of the heat conducting structure 160 is greater than or equal to 200W/m-K. The heat conducting structure 160 may be a conductor or a non-conductor. If there is a need for grounding, a conductor may be selected for the heat conducting structure 160. In addition, the heat conducting structure 160 may be metal, such as aluminum, gold, silver or copper, but the type of the heat conducting structure 160 is not limited thereto. In an embodiment, the heat conducting structure 160 may be a high thermal conductivity compound such as graphene, silicon carbide or aluminum nitride, but the type of the heat conducting structure 160 is not limited thereto. Additionally, although an insulating material are usually used to serve as a material for the heat interposer 170, in some implementations, when the radio-frequency integrated circuit 130 needs to achieve the need for grounding through the fourth surface 134, the heat interposer 170 may include a conductive material. A thickness of the heat interposer 170 is less than 20 microns, such as 10 microns.

As shown in FIG. 1C, an outer surface of the heat conducting structure 160 is flush with the second ends 144 of the metal pillars 140. The outer surface of the heat conducting structure 160 and the second ends 144 of the metal pillars 140 are exposed from the encapsulation 150. Therefore, the integrated antenna device 100 may also selectively be disposed on a heat dissipating plane (not shown). The heat generated by the antenna 120, the substrate 110, and the radio-frequency integrated circuit 130 may be transmitted to the outside through the metal pillars 140 and the heat conducting structure 160, thereby achieving a good heat dissipation effect.

In the embodiment, the entire heat conducting structure 160 is exposed from the encapsulation 150, which may increase the contact area with air and enhance heat dissipation. Certainly, in an embodiment, the heat conducting structure 160 may also be partially encapsulated by the encapsulation 150, and the disclosure is not limited to FIG. 1C.

FIG. 2 is a schematic cross-sectional view of an integrated antenna device according to another embodiment of the disclosure. Please refer to FIG. 2. The main difference between an integrated antenna device 100a in FIG. 2 and the integrated antenna device 100 in FIG. 1C is that in the embodiment, the encapsulation 150 encapsulates the entire radio-frequency integrated circuit 130, the heat interposer 170, and encapsulates a part of the heat conducting structure 160 other than an outer surface and a part of the metal pillars 140 other than the second ends 144. Therefore, the encapsulation 150 only exposes the outer surface of the heat conducting structure 160 and the second ends 144 of the metal pillars 140.

In addition, the multiple solder balls 119 are disposed on an outer surface of the heat conducting structure 160 and the second ends 144 of the metal pillars 140. Of course, in an embodiment, the outer surface of the heat conducting structure 160 may also be provided with other forms of solder, such as solder sheet or solder paste. The disclosure is not limited by the figure.

This design may allow the elements of the integrated antenna device 100a to be more secure and stable. The heat generated by the radio-frequency integrated circuit 130, the antenna 120, and the substrate 110 may still be transmitted to the outside through the outer surface of the heat conducting structure 160 and the second ends 144 of the metal pillars 140, thereby having good heat dissipation performance.

A method of manufacturing the integrated antenna device 100 in FIG. 1C will be described below.

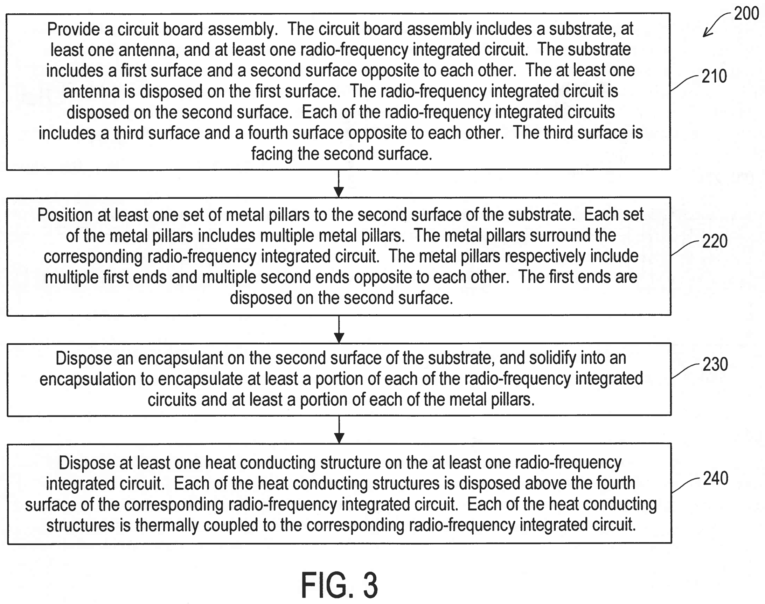

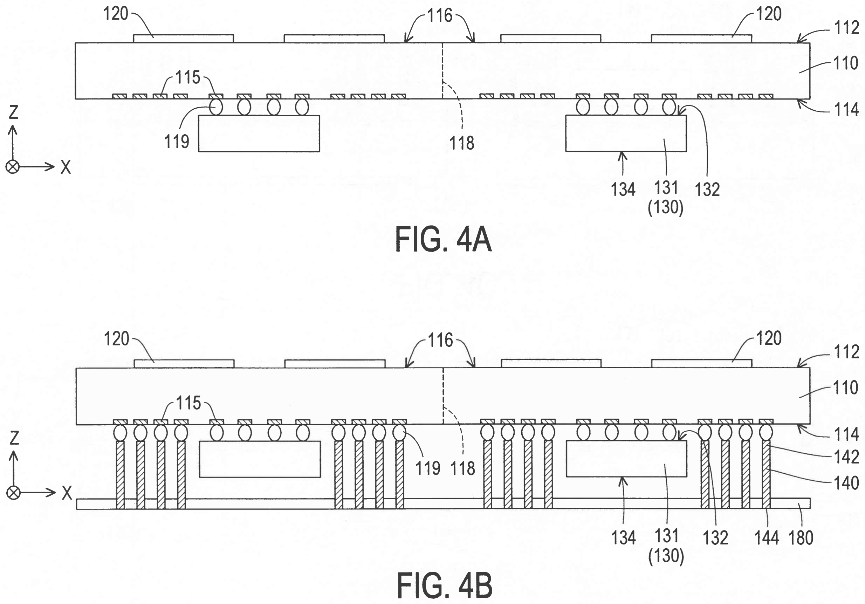

FIG. 3 is a schematic flow chart of a method of manufacturing the integrated antenna device 100 according to an embodiment of the disclosure. FIG. 4A to FIG. 4G are schematic views of a process of manufacturing the integrated antenna device in FIG. 1C. It should be noted that FIG. 4A to FIG. 4G only illustratively takes the manufacturing of two sets of the integrated antenna devices 100 as an example, but the process in FIG. 3 may also manufacture a larger quantity of the integrated antenna devices 100, or the single integrated antenna device 100, and the disclosure is not limited by the drawing.

Please refer to FIG. 3 and FIG. 4A first. A method 200 of manufacturing an integrated antenna device in the embodiment includes the following steps. First, as in step 210 of FIG. 3, a circuit board assembly is provided. The circuit board assembly includes the substrate 110, the at least one antenna 120, and the at least one radio-frequency integrated circuit 130. The substrate 110 includes the first surface 112 and the second surface 114 opposite to each other. The at least one antenna 120 is disposed on the first surface 112. The radio-frequency integrated circuit 130 is disposed on the second surface 114. Each of the radio-frequency integrated circuits 130 includes the third surface 132 and the fourth surface 134 opposite to each other. The third surface 132 is facing the second surface 114.

In the embodiment, the substrate 110 is divided into multiple sub-regions 116 arranged in an array. The sub-regions 116 are spaced apart by multiple precut lines 118. The substrate 110 in FIG. 4A takes two sub-regions 116 for illustration. The at least one radio-frequency integrated circuit 130 includes multiple radio-frequency integrated circuits 130, taking two for illustration in FIG. 4A, but the disclosure is not limited thereto. The at least one antenna 120 includes multiple antennas 120. The antennas 120 and the two radio-frequency integrated circuits 130 are respectively disposed in the two sub-regions 116.

Next, as shown in step 220 of FIG. 3 and FIG. 4B, at least one set of metal pillars 140 is positioned to the second surface 114 of the substrate 110. Each set of the metal pillars 140 includes multiple metal pillars 140. The metal pillars 140 surround the corresponding radio-frequency integrated circuit 130. The metal pillars 140 respectively include the multiple first ends 142 and the multiple second ends 144 opposite to each other. The first ends 142 are disposed on the second surface 114.

In the embodiment, the at least one set of metal pillars 140 includes multiple sets of metal pillars 140, such as two sets, disposed in the two sub-regions 116. The two sets of metal pillars 140 respectively surround the two radio-frequency integrated circuits 130.

It is worth mentioning that the metal pillars 140 are arranged in a form of an array. In order to allow the metal pillars 140 to be well positioned to the electrical contacts on the second surface 114 of the substrate 110, in a step of positioning each set of the the metal pillars 140 to the second surface 114 of the substrate 110, the manufacturing method further includes a hot-melt adhesive 180 being covered on the second ends 144 of the metal pillars 140 in each set of the metal pillars 140 to position the metal pillars 140. In an embodiment, a melting point of the hot-melt adhesive 180 is less than 85 degrees Celsius.

In other words, before the metal pillars 140 are disposed on the second surface 114 of the substrate 110, the metal pillars 140 may be arranged, and the second ends 144 may be fixed at a relative position by the hot-melt adhesive 180. Afterwards, the metal pillars 140 fixed at the relative position by the hot-melt adhesive 180 are positioned to the second surface 114 of the substrate 110.

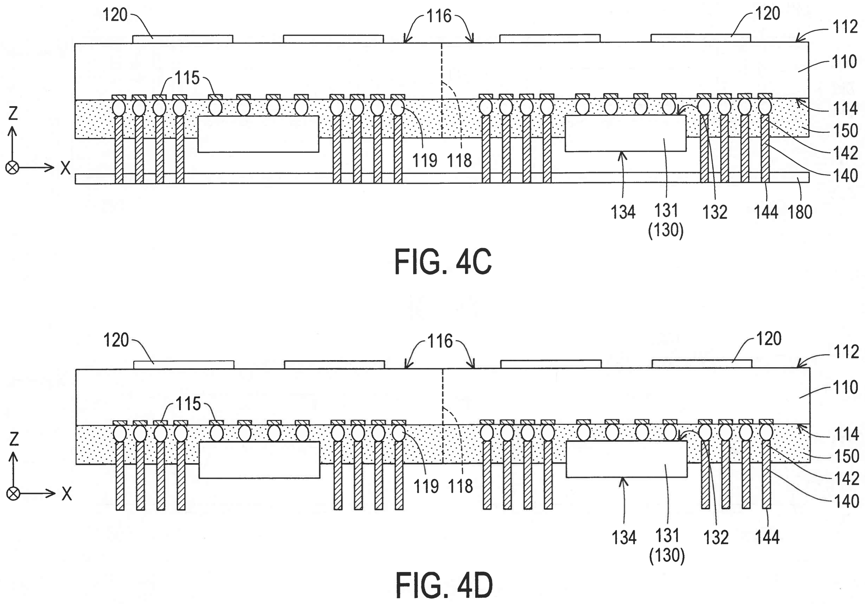

Next, as shown in step 230 of FIG. 3 and FIG. 4C, an encapsulant is disposed on the second surface 114 of the substrate 110, and is heated to 120 degrees Celsius for 20 minutes in an oven, with a relative humidity below 60%. Alternatively, the embodiment is heated to 130 degrees Celsius for 30 minutes in an oven, with a relative humidity below 60%. Alternatively, the embodiment is heated to 80 degrees Celsius for 60 minutes, with a relative humidity below 60%. The encapsulant may be solidified into the encapsulation 150 to encapsulate at least a portion of each of the radio-frequency integrated circuits 130 and at least a portion of each of the metal pillars 140.

In the embodiment, the encapsulation 150 encapsulates a portion of each of the radio-frequency integrated circuits 130 and a portion of each of the metal pillars 140, and exposes another portion of each of the radio-frequency integrated circuits 130 and another portion of each of the metal pillars 140. The encapsulation 150 does not encapsulate the hot-melt adhesive 180.

Next, as shown in FIG. 4D, after a step of solidifying the encapsulant into the encapsulation 150, the manufacturing method further includes the hot-melt adhesive 180 being removed by heating to expose the second ends 144 of the metal pillars 140.

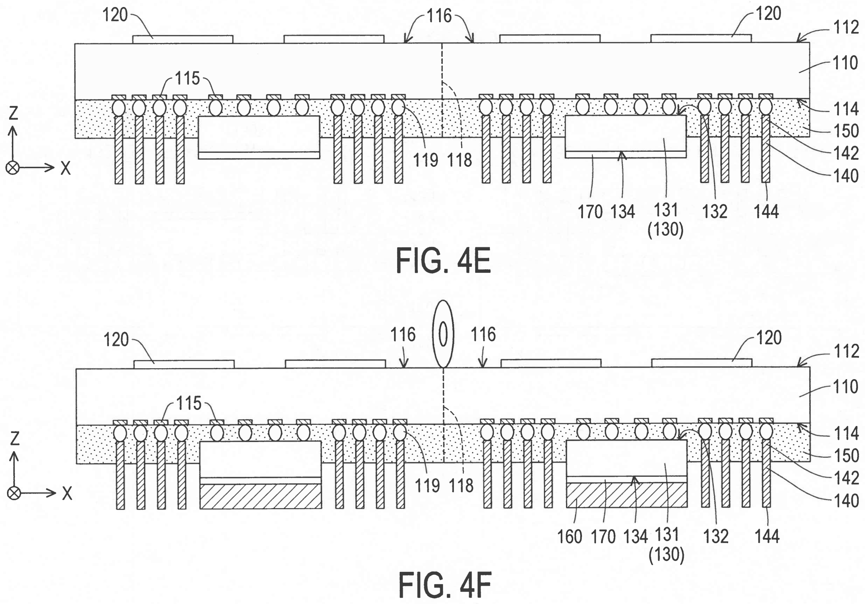

Next, as shown in FIG. 4E, the at least one heat interposer 170 is disposed on the at least one radio-frequency integrated circuit 130. Each of the heat interposers 170 is disposed on the fourth surface 134 of the corresponding radio-frequency integrated circuit 130. In the embodiment, a quantity of the heat interposers 170 is two, which corresponds to the quantity of the radio-frequency integrated circuits 130.

As shown in step 240 of FIG. 3 and FIG. 4F, the at least one heat conducting structure 160 is disposed on the at least one radio-frequency integrated circuit 130. Each of the heat conducting structures 160 is disposed above the fourth surface 134 of the corresponding radio-frequency integrated circuit 130. Each of the heat conducting structures 160 is thermally coupled to the corresponding radio-frequency integrated circuit 130. Specifically, in the embodiment, the at least one heat conducting structure 160 includes the multiple heat conducting structures 160, such as two. Each of the heat conducting structures 160 is disposed on the corresponding heat interposer 170 to be thermally coupled to the corresponding radio-frequency integrated circuit 130.

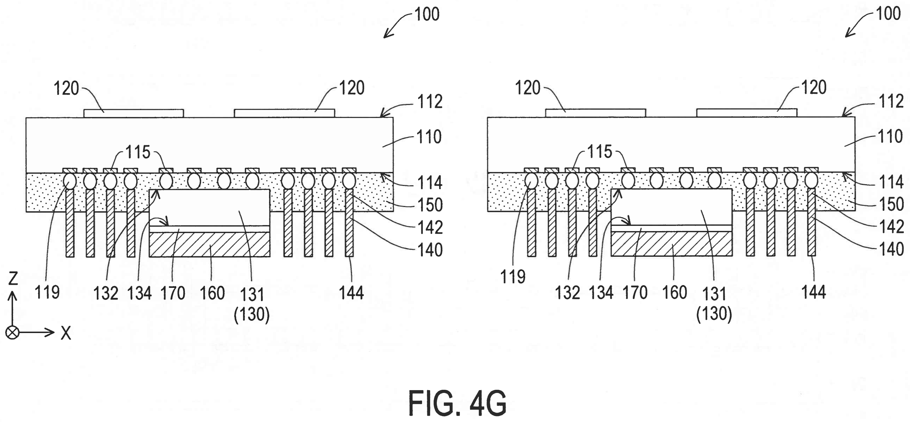

Finally, as shown in FIG. 4G, the encapsulation 150 and the circuit board assembly are cut along the precut lines 118 to obtain the multiple integrated antenna devices 100. An outer surface of the heat conducting structure 160 of each of the integrated antenna devices 100 is exposed from the corresponding encapsulation 150. In the embodiment, a thickness of the heat conducting structure 160 may be selected so that the outer surface of each of the heat conducting structures 160 is flush with the second ends 144 of the corresponding metal pillars 140.

The integrated antenna device 100 may be manufactured by the foregoing method. The heat generated by the integrated antenna device 100 may be transmitted to the outside through the metal pillars 140 and the heat conducting structure 160, thereby achieving a good heat dissipation effect.

A method of manufacturing the integrated antenna device 100a in FIG. 2 will be described below.

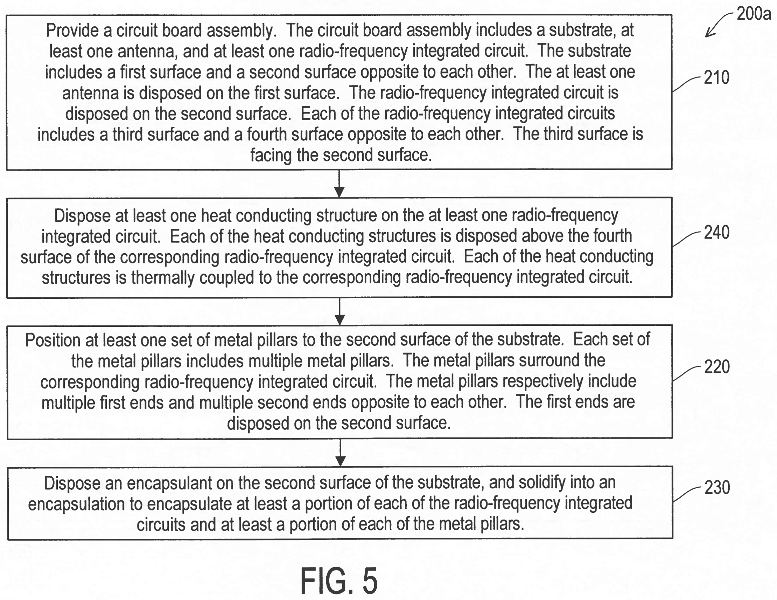

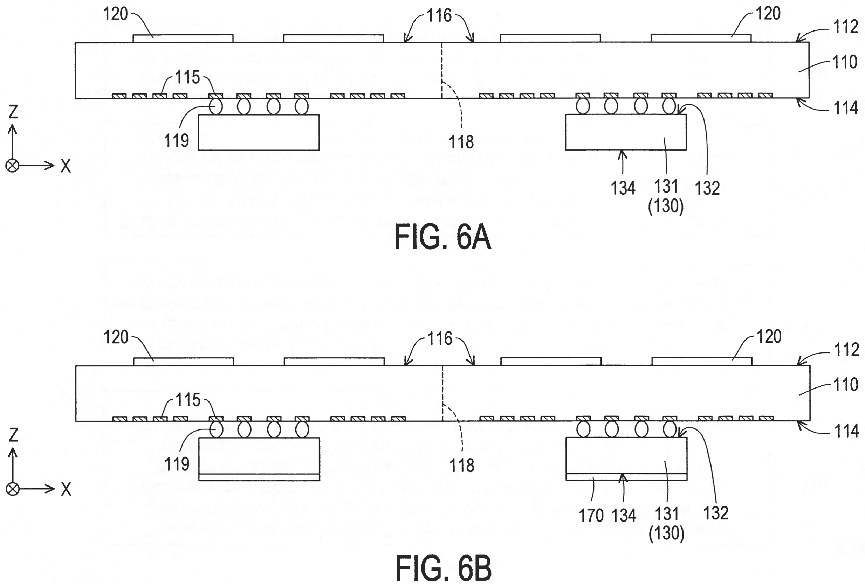

FIG. 5 is a schematic flow chart of a method of manufacturing an integrated antenna device according to another embodiment of the disclosure. FIG. 6A to FIG. 6G are schematic views of a process of manufacturing the integrated antenna device in FIG. 2. Similarly, FIG. 6A to FIG. 6G illustratively take the manufacturing of two sets of integrated antenna devices 100a as an example, but the process of FIG. 5 may also manufacture a larger quantity of the integrated antenna devices 100a, or the single integrated antenna device 100a, and the disclosure is not limited by the drawing.

A method 200a of manufacturing the integrated antenna device includes the following steps: please refer to FIG. 5 and FIG. 6A first. First, as shown in step 210 of FIG. 5, a circuit board assembly is provided. The circuit board assembly includes the substrate 110, the at least one antenna 120, and the at least one radio-frequency integrated circuit 130. The substrate 110 includes the first surface 112 and the second surface 114 opposite to each other. The at least one antenna 120 is disposed on the first surface 112. The radio-frequency integrated circuit 130 is disposed on the second surface 114. Each of the radio-frequency integrated circuits 130 includes the third surface 132 and the fourth surface 134 opposite to each other. The third surface 132 is facing the second surface 114.

In the embodiment, the substrate 110 is divided into the multiple sub-regions 116 arranged in an array. The sub-regions 116 are spaced apart by the multiple precut lines 118. The substrate 110 in FIG. 6A takes the two sub-regions 116 as an example, but the enclosure is not limited thereto. The at least one radio-frequency integrated circuit 130 includes multiple radio-frequency integrated circuits 130, taking two as an example in FIG. 6A, but the enclosure is not limited thereto. The at least one antenna 120 includes multiple antennas 120. The antennas 120 and the two radio-frequency integrated circuits 130 are respectively disposed in the two sub-regions 116.

Next, as shown in FIG. 6B, the at least one heat interposer 170 is disposed on the at least one radio-frequency integrated circuit 130. Each of the heat interposers 170 is disposed on the fourth surface 134 of the corresponding radio-frequency integrated circuit 130. In the embodiment, a quantity of the heat interposers 170 is two, which corresponds to the quantity of the radio-frequency integrated circuits 130.

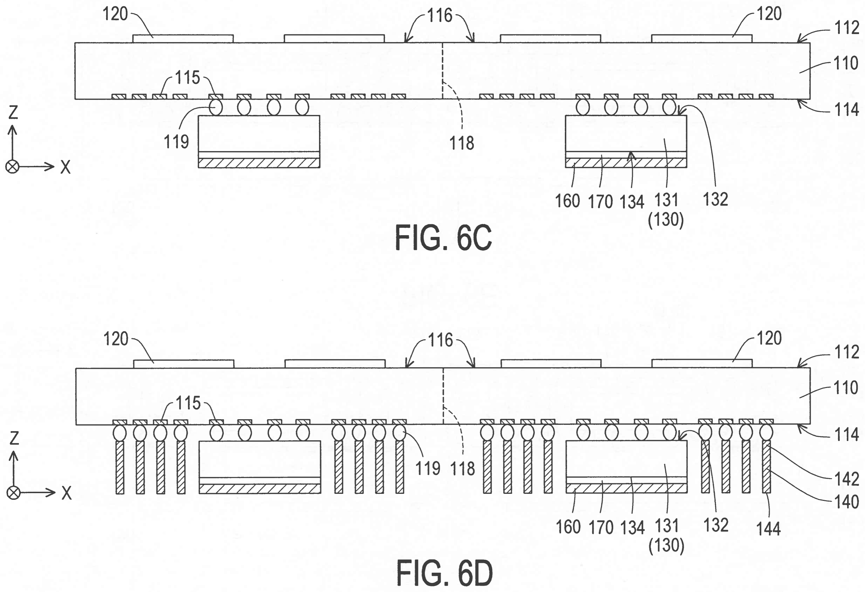

Then, as shown in step 240 of FIG. 5 and FIG. 6C, the at least one heat conducting structure 160 is disposed on the at least one radio-frequency integrated circuit 130. Each of the heat conducting structures 160 is disposed above the fourth surface 134 of the corresponding radio-frequency integrated circuit 130. Each of the heat conducting structure 160 is thermally coupled to the corresponding radio-frequency integrated circuit 130. Specifically, in the embodiment, the at least one heat conducting structure 160 includes the multiple heat conducting structures 160, such as two. Each of the heat conducting structures 160 is disposed on the corresponding heat interposer 170 to be thermally coupled to the corresponding radio-frequency integrated circuit 130.

Next, as shown in step 220 of FIG. 5 and FIG. 6D, the at least one set of metal pillars 140 is positioned to the second surface 114 of the substrate 110. Each set of the metal pillars 140 includes multiple metal pillars 140. The metal pillars 140 surround the corresponding radio-frequency integrated circuit 130. The metal pillars 140 respectively include the multiple first ends 142 and the multiple second ends 144 opposite to each other. The first ends 142 are disposed on the second surface 114.

In the embodiment, the at least one set of metal pillars 140 includes multiple sets of metal pillars 140, such as two sets, disposed in the two sub-regions 116. The two sets of metal pillars 140 respectively surround the two radio-frequency integrated circuits 130, the two heat interposers 170, and the two heat conducting structures 160.

As seen in FIG. 6D, after this step is completed, a height of each set of the metal pillars 140 protruding from the second surface 114 is greater than a height of the heat conducting structure 160 relative to the second surface 114. In other words, the second ends 144 of the metal pillars 140 are higher than the outer surface of the heat conducting structure 160.

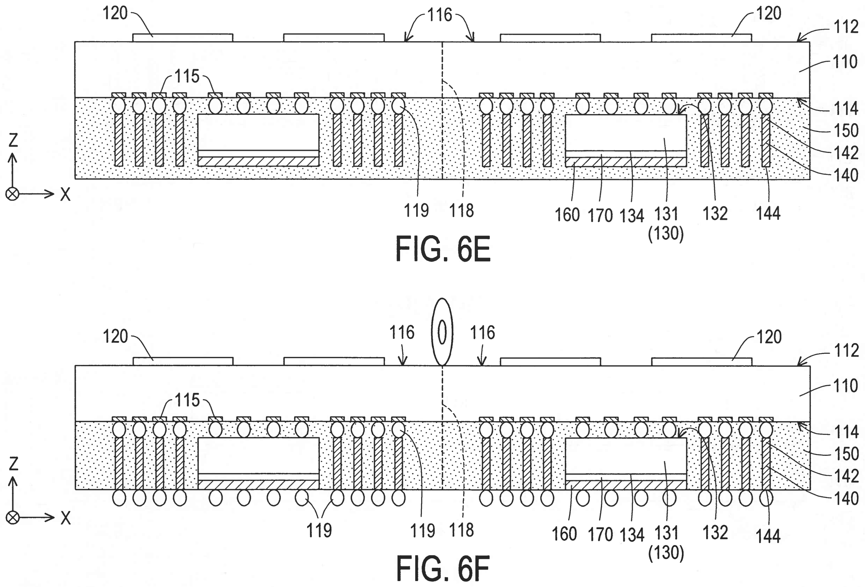

Then, as shown in step 230 of FIG. 5 and FIG. 6E, an encapsulant is disposed on the second surface 114 of the substrate 110, and solidified into the encapsulation 150 to encapsulate at least a portion of each of the radio-frequency integrated circuits 130 and at least a portion of each of the metal pillars 140.

In the embodiment, after this step is completed, the encapsulation 150 encapsulates each of the radio-frequency integrated circuits 130, each of the heat interposers 170, each of the heat conducting structures 160, and each of the metal pillars 140, and only exposes the second ends 144 of the metal pillars 140. In other embodiments, the encapsulation 150 may also cover the second ends 144 of the metal pillars 140.

Next, as shown in FIG. 6F, the encapsulation 150 is polished until the outer surface of each of the heat conducting structures 160 is exposed from the encapsulation 150, and the outer surface of the heat conducting structure 160 is flush with the second ends 144 of the corresponding metal pillars 140. Next, the multiple solder balls 119 are disposed on the outer surface of the heat conducting structure 160 and the second ends 144 of the metal pillars 140. Of course, in an embodiment, the outer surface of the heat conducting structure 160 may also be provided with other forms of solder, such as solder sheet or solder paste. The disclosure is not limited by the figure.

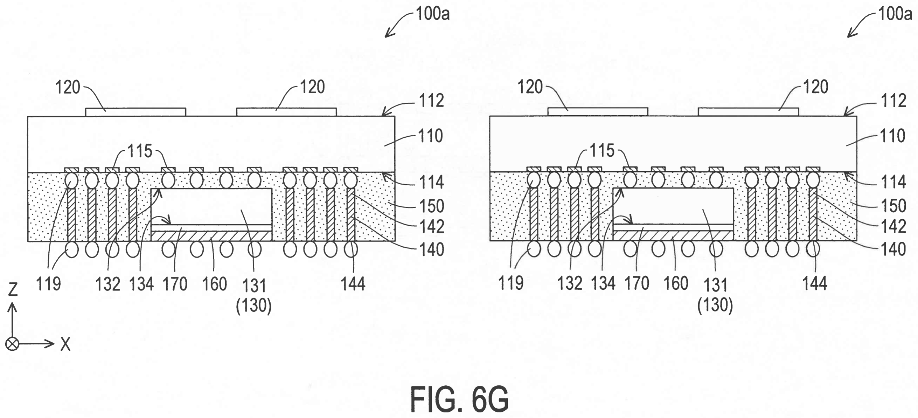

Finally, as shown in FIG. 6G, the encapsulation 150 and the circuit board assembly are cut along the precut lines 118 to obtain the multiple integrated antenna devices 100. The outer surface of the heat conducting structure 160 of each of the integrated antenna devices 100 is exposed from the corresponding encapsulation 150. The outer surface is flush with the second ends 144 of the corresponding metal pillars 140.

By means of the above method, the integrated antenna device 100a may be manufactured. The heat generated by the integrated antenna device 100a may be transmitted to the outside through the metal pillars 140 and the heat conducting structure 160, thereby achieving a good heat dissipation effect.

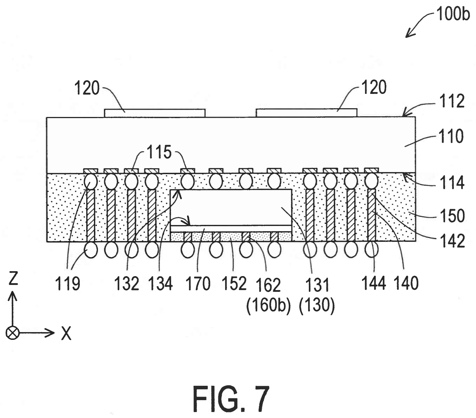

FIG. 7 is a schematic cross-sectional view of an integrated antenna device according to another embodiment of the disclosure. Please refer to FIG. 7. The main difference between an integrated antenna device 100b and the integrated antenna device 100a is in the forms of the heat conducting structure 160 and a heat conducting structure 160b. In the embodiment, the heat conducting structure 160b includes multiple heat conducting pillars 162 separating from each other. The heat conducting pillars 162 are encapsulated by an encapsulation 152 and fixed.

Likewise, the heat generated by the integrated antenna device 100b in FIG. 7 may be transmitted to the outside through the metal pillars 140 and the heat conducting pillars 162 of the heat conducting structure 160b, thereby achieving a good heat dissipation effect.

Next, a process of manufacturing the integrated antenna device 100b in FIG. 7 will be described. First, a process of manufacturing a radio-frequency integrated circuit module 189 in the integrated antenna device 100b in FIG. 7 is described.

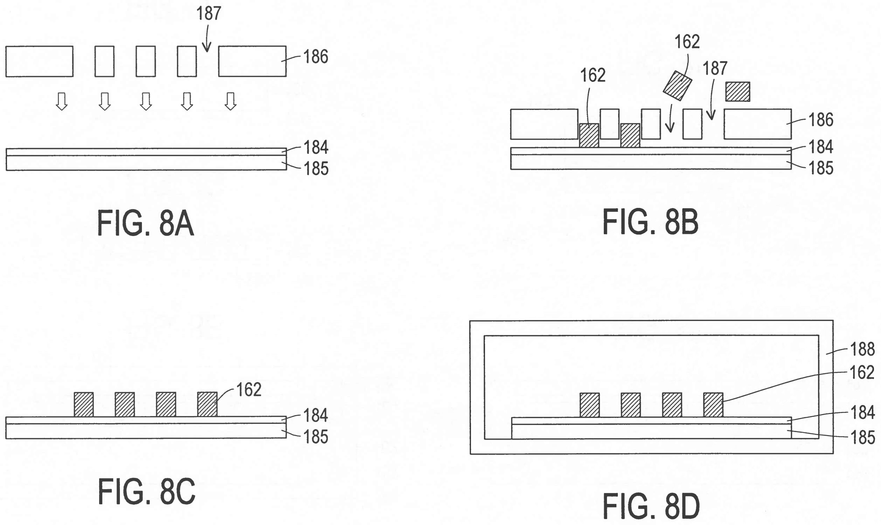

FIG. 8A to FIG. 8I are schematic views of a process of manufacturing the radio-frequency integrated circuit module of the integrated antenna device in FIG. 7. Referring to FIG. 8A first, a first vehicle 185 having a first adhesive layer 184 is provided, and a first guide structure 186 is disposed above the first vehicle 185. The first guide structure 186 includes multiple first perforations 187.

Next, referring to FIG. 8B, multiple ends of the multiple heat conducting pillars 162 are allowed to contact the first adhesive layer 184, and be fixed on the first vehicle 185. Then, as shown in FIG. 8C, the first guide structure 186 is removed.

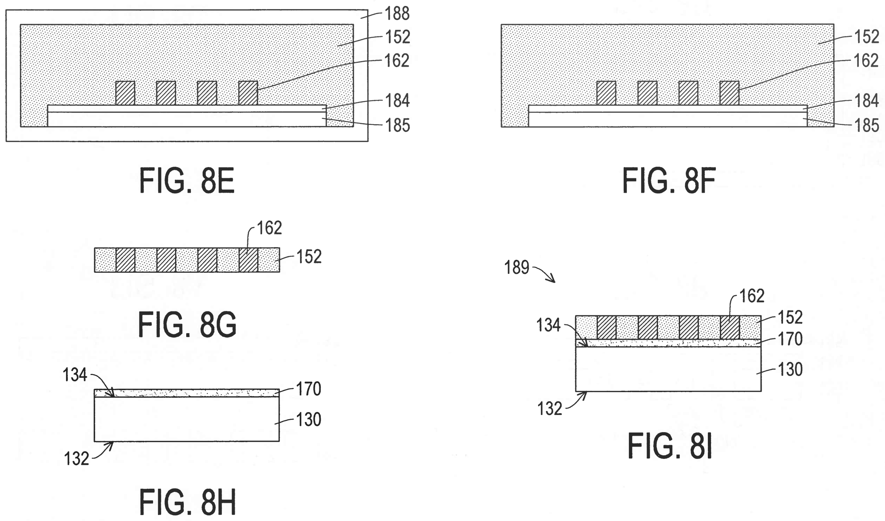

Then, as shown in FIG. 8D, the first vehicle 185 together with the first adhesive layer 184 and the heat conducting pillars 162 are placed in a mold 188. As shown in FIG. 8E, an encapsulant is injected into the mold 188, and the encapsulant is solidified into the encapsulation 152 to encapsulate the heat conducting pillars 162. Then, as shown in FIG. 8F, the first vehicle 185, the first adhesive layer 184, and the heat conducting pillars 162 that are encapsulated by the encapsulation 152 are taken out from the mold 188. That is to say, during the stages from FIG. 8D to FIG. 8F, the encapsulant is disposed on the first vehicle 185, and solidified into the encapsulation 152 to encapsulate the heat conducting pillars 162.

Then, referring to FIG. 8G, two opposite ends of each of the heat conducting pillars 162 that are encapsulated by the encapsulation 152 are allowed to be exposed. In the embodiment, this step may be performed through a manner such as polishing to remove the first vehicle 185, the first adhesive layer 184, and a portion of the encapsulation 152.

Then, referring to FIG. 8H, the radio-frequency integrated circuit 130 is provided. In the embodiment, the fourth surface 134 of the radio-frequency integrated circuit 130 is provide with the heat interposer 170.

Referring to FIG. 8I, one end of each of the heat conducting pillars 162 that are exposed from the encapsulation 152 is allowed to be disposed above the fourth surface 134 of the radio-frequency integrated circuit 130 and thermally coupled to the radio-frequency integrated circuit 130. In the embodiment, the ends of the heat conducting pillars 162 that are exposed from the encapsulation 152 are connected to the heat interposer 170 to be thermally coupled to the radio-frequency integrated circuit 130. In an embodiment, the encapsulation 152 may be made of a material whose coefficient of thermal expansion is close to a coefficient of thermal expansion of the radio-frequency integrated circuit 130, so that the thermal stress may be dispersed, and the heat interposer 170 is not easily cracked.

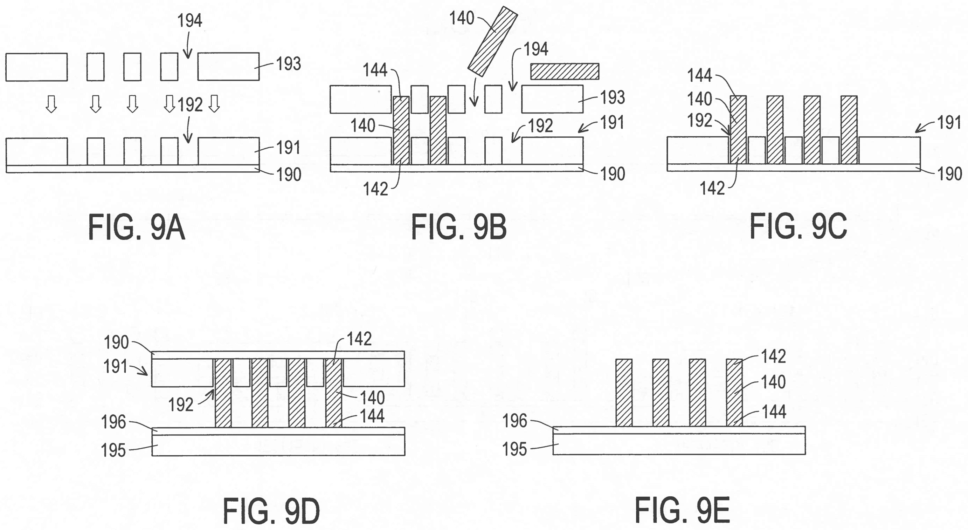

A process of positioning the metal pillars 140 of the integrated antenna device 100b in FIG. 7 will be described below. FIG. 9A to FIG. 9E are schematic views of a process of positioning the metal pillars of the integrated antenna device in FIG. 7. Referring to FIG. 9A first, a mask 191 fixed on a second adhesive layer 190 is provided, and a second guide structure 193 is disposed above the mask 191. The mask 191 includes multiple second perforations 192. The second guide structure 193 includes multiple third perforations 194. The third perforations 194 are positioned to the second perforations 192.

Next, referring to FIG. 9B, the metal pillars 140 are extended into the third perforations 194 of the second guide structure 193 and the second perforations 192 of the mask 191. The first ends 142 of the metal pillars 140 are allowed to be fixed on the second adhesive layer 190. Then, referring to FIG. 9C, the second guide structure 193 is removed.

Next, referring to FIG. 9D, the structure of FIG. 9C is flipped. The metal pillars 140 are moved next to a second vehicle 195 having a third adhesive layer 196. The second ends 144 of the metal pillars 140 are allowed to contact the third adhesive layer 196 to allow the metal pillars 140 to be fixed on the second vehicle 195.

Referring to FIG. 9E, the second adhesive layer 190 is separated from the metal pillars 140, and the metal pillars 140 that are fixed on the second vehicle 195 are allowed to expose the first ends 142. In addition, the second adhesive layer 190 and the mask 191 are removed.

Next, a process of manufacturing the integrated antenna device 100b in FIG. 7 will be described.

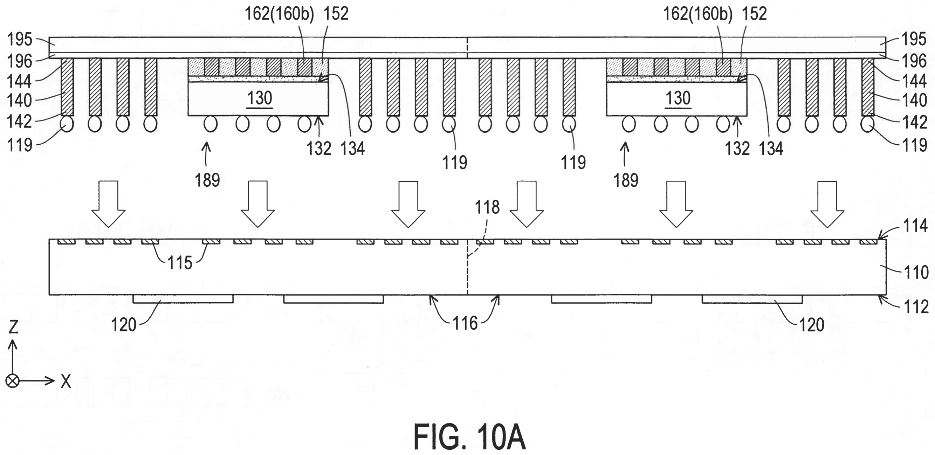

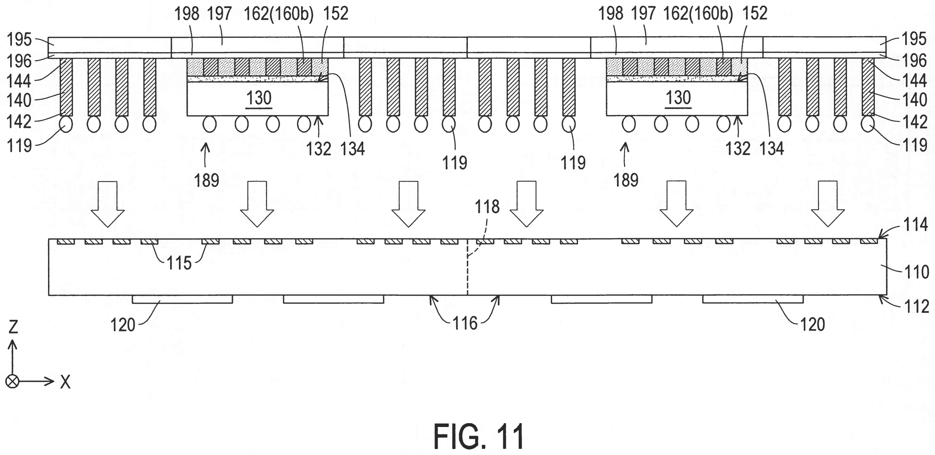

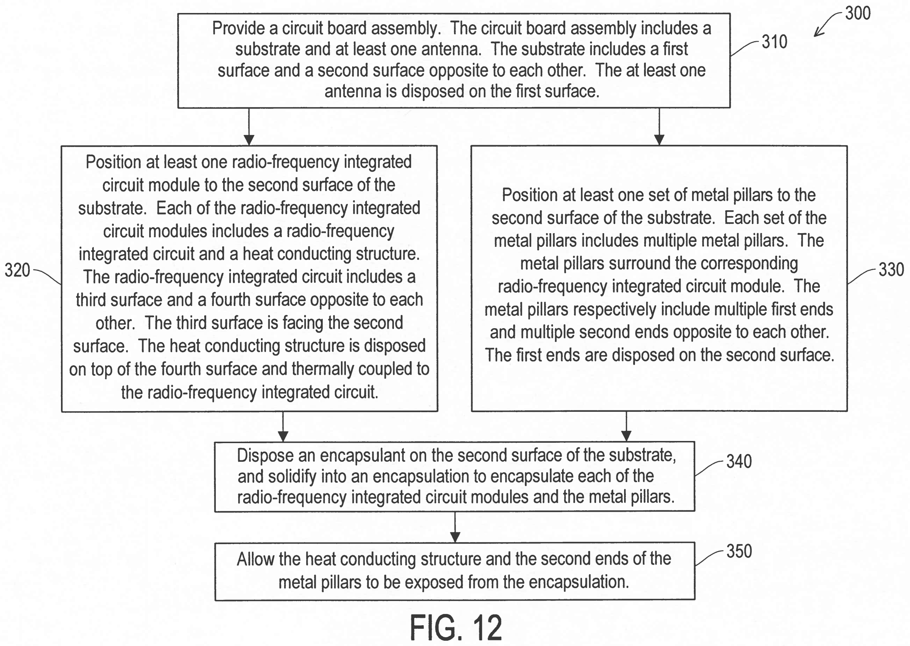

FIG. 10A to FIG. 10F are schematic views of a process of manufacturing the integrated antenna device in FIG. 7. FIG. 11 is a schematic view of another embodiment of FIG. 10A. FIG. 12 is a schematic flow chart of a method of manufacturing an integrated antenna device according to another embodiment of the disclosure.

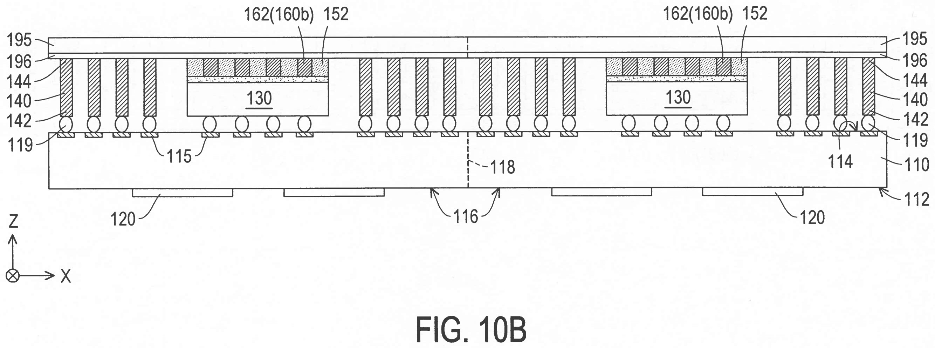

Please refer to FIG. 10A, FIG. 10B, and FIG. 12 at the same time first. A method 300 of manufacturing an integrated antenna device of the embodiment includes the following steps. First, in step 310, a circuit board assembly is provided. The circuit board assembly includes the substrate 110 and the at least one antenna 120. The substrate 110 includes the first surface 112 and the second surface 114 opposite to each other. The at least one antenna 120 is disposed on the first surface 112. In the embodiment, a quantity of the antenna 12 is, for example, two sets, but the quantity of the antenna 120 is not limited thereto.

Next, as step 320, the at least one radio-frequency integrated circuit module 189 is positioned to the second surface 114 of the substrate 110. Each of the radio-frequency integrated circuit modules 189 includes the radio-frequency integrated circuit 130 and the heat conducting structure 160b. The radio-frequency integrated circuit 130 includes the third surface 132 and the fourth surface 134 opposite to each other. The third surface 132 is facing the second surface 114. The heat conducting structure 160b is disposed above the fourth surface 134 and thermally coupled to the radio-frequency integrated circuit 130. In the embodiment, a quantity of the radio-frequency integrated circuit module 189 is, for example, two, but the quantity of the radio-frequency integrated circuit module 189 is not limited thereto.

In addition, as step 330, at least one set of the metal pillars 140 is positioned to the second surface 114 of the substrate 110. In the embodiment, a quantity of the metal pillars is multiple sets, surrounding an outer side of the radio-frequency integrated circuit module 189. Each set of the metal pillars 140 includes multiple metal pillars 140. The metal pillars 140 surround the corresponding radio-frequency integrated circuit module 189. The metal pillars 140 respectively include the multiple first ends 142 and the multiple second ends 144 opposite to each other. The first ends 142 are facing and disposed on the second surface 114.

It is worth mentioning that in the embodiment, before steps 320 and 330 are performed, the heat conducting structure 160b of the radio-frequency integrated circuit module 189 may be fixed on the third adhesive layer 196 on the second vehicle 195, and the heat conducting structure 160b is allowed to be positioned between the radio-frequency integrated circuit 130 and the second vehicle 195. As shown in FIG. 10A, the radio-frequency integrated circuit module 189 is surrounded by the metal pillars 140. The third surface 132 of the radio-frequency integrated circuit 130 is flush with the first ends 142 of the metal pillars 140. Then, the third surface 132 of the radio-frequency integrated circuit 130 and the first ends 142 of the metal pillars 140 may be provided with the multiple solder balls 119.

Next, step 320 of positioning the at least one radio-frequency integrated circuit module 189 to the second surface 114 of the substrate 110 and step 330 of positioning the at least one set of the metal pillars 140 to the second surface 114 of the substrate 110 may be executed at a same time, thereby reducing process. The solder balls 119 on the third surface 132 of the radio-frequency integrated circuit 130 and the solder balls 119 on the first ends 142 of the metal pillars 140 are connected to the electrical contacts 115 on the second surface 114 of the substrate 110.

It is to be noted that in another embodiment, the heat conducting structure 160b of the radio-frequency integrated circuit module 189 may also not be fixed on the second vehicle 195, and may be positioned on a structure independent of the second vehicle 195. Please refer to FIG. 11. The main difference between FIG. 11 and FIG. 10A is that the heat conducting structure 160b of each of the radio-frequency integrated circuit modules 189 is fixed on a third vehicle 197 having a fourth adhesive layer 198, and the heat conducting structure 160b is allowed to be positioned between the radio-frequency integrated circuit 130 and the third vehicle 197. The third vehicle 197 is separated from the second vehicle 195, thereby having more flexibility in positioning.

In the embodiment of FIG. 11, since the third vehicle 197 is separated from the second vehicle 195, step 320 may be performed before step 330. Alternatively, step 320 may be performed after step 330. Alternatively, step 320 and step 330 may be performed at a same time.

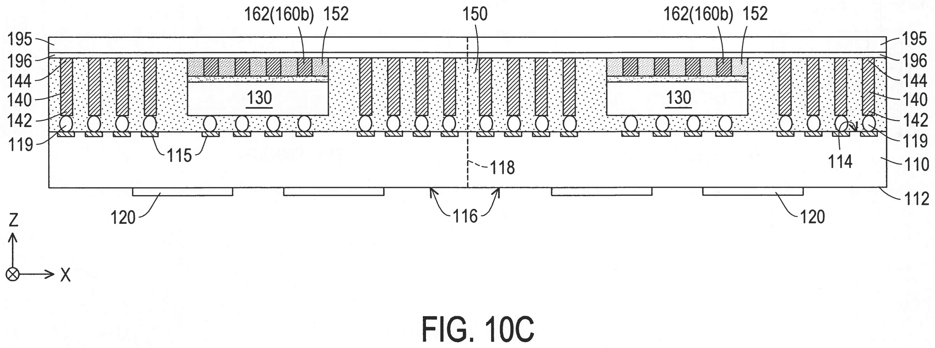

Next, please return to FIG. 10C and FIG. 12. Performing step 340, an encapsulant is disposed on the second surface 114 of the substrate 110, and solidified into the encapsulation 150 to encapsulate each of the radio-frequency integrated circuit modules 189 and the metal pillars 140. In the embodiment, the encapsulation 150 is formed in a space between on the second surface 114 of the substrate 110 and the third adhesive layer 196, and each of the radio-frequency integrated circuit modules 189 and the metal pillars 140 are allowed to be encapsulated.

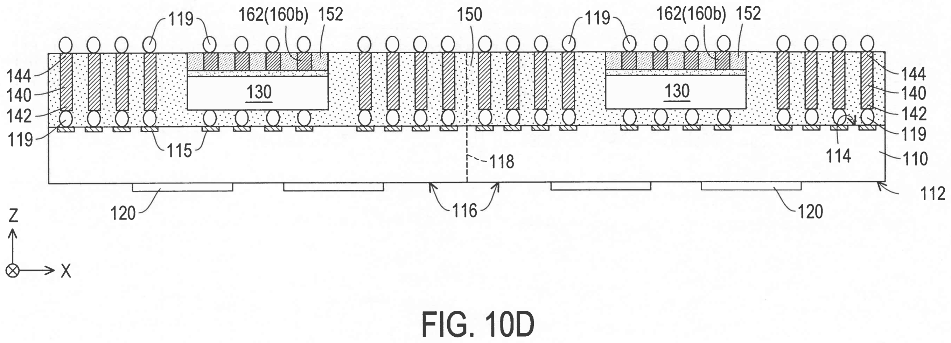

Then, please refer to FIG. 10D and FIG. 12. In step 350, the heat conducting structure 160b and the second ends 144 of the metal pillars are allowed to be exposed from the encapsulation 150. In step 350, the encapsulation 150 may be polished until each of the heat conducting structures 160b and the second ends 144 of the corresponding metal pillars 140 are exposed from the encapsulation 150. The second vehicle 195 and the third adhesive layer 196 are removed in such a way that exposed surfaces of the heat-conducting pillars 162 of each of the heat-conducting structures 160b are flush with the second ends 144 of the corresponding metal pillars 140 to allow the heat-conducting pillars 162 of the heat-conducting structures 160b and the second ends 144 of the metal pillars 140 to be exposed, but the removing method is not limited thereto. Next, the ends of the heat conducting pillars 162 of the heat conducting structure 160b and the second ends 144 of the metal pillars 140 are provided with the multiple solder balls 119.

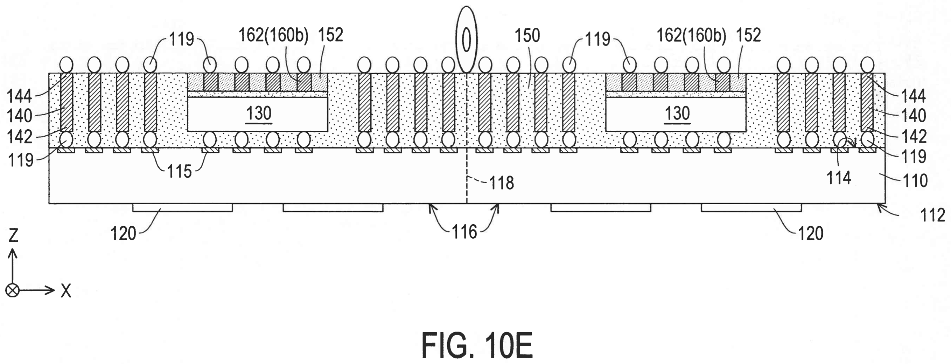

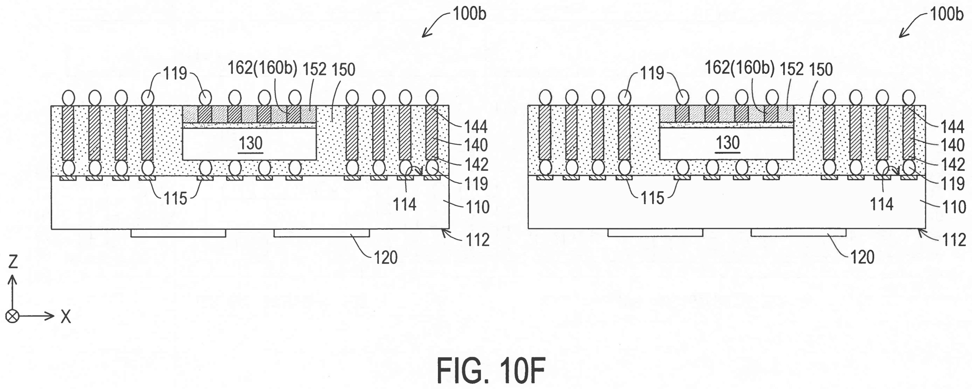

Finally, please refer to FIG. 10E and FIG. 10F. The encapsulation 150 and the circuit board assembly are cut along the precut lines 118 to obtain the multiple integrated antenna devices 100b. The integrated antenna device 100b may be manufactured by the foregoing method. The heat generated by the integrated antenna devices 100b may be transmitted to the outside through the metal pillars 140 and the heat conducting structure 160b, thereby achieving a good heat dissipation effect.

In summary, according to the integrated antenna device of the disclosure, the antenna is disposed on the first surface of the substrate. The radio-frequency integrated circuit is disposed on the second surface of the substrate. This design may allow the antenna and the radio-frequency integrated circuit to be integrated together. In addition, the first ends of the metal pillars are disposed on the second surface of the substrate. The metal pillars surround the radio-frequency integrated circuit. The encapsulation is disposed on the second surface of the substrate, encapsulating at least a portion of the radio-frequency integrated circuit and at least a portion of each of the metal pillars to fix the metal pillars. The heat conducting structure is disposed above the fourth surface and thermally coupled to the radio-frequency integrated circuit. The outer surface of the heat conducting structure is flush with the second ends of the metal pillars. The outer surface of the heat conducting structure and the second ends of the metal pillars are flush with and exposed from the encapsulation. Therefore, the heat generated by the substrate and the radio-frequency integrated circuit may be transmitted to the outside through the metal pillars and the heat conducting structure, thereby achieving a good heat dissipation effect.

## Claims

1. A method (200, 200a, 300) of manufacturing an integrated antenna device (100, 100a, 100b), comprising:
providing a circuit board assembly, wherein the circuit board assembly comprises a substrate (110) and at least one antenna (120), the substrate (110) comprises a first surface (112) and a second surface (114) opposite to each other, and the at least one antenna (120) is disposed on the first surface (112);
positioning at least one radio-frequency integrated circuit module (189) to the second surface (114) of the substrate (110), wherein each of the radio-frequency integrated circuit modules (189) comprises a radio-frequency integrated circuit (130) and a heat conducting structure (160, 160b), the radio-frequency integrated circuit (130) comprises a third surface (132) and a fourth surface (134) opposite to each other, the third surface (132) is facing the second surface (114), and the heat conducting structure (160, 160b) is disposed above the fourth surface (134) and thermally coupled to the radio-frequency integrated circuit (130);
positioning at least one set of metal pillars (140) to the second surface (114) of the substrate (110), wherein each set of the metal pillars (140) comprises the plurality of metal pillars (140), the metal pillars (140) surround the corresponding radio-frequency integrated circuit (130), the metal pillars (140) respectively comprise a plurality of first ends (142) and a plurality of second ends (144) opposite to each other, and the first ends (142) are disposed on the second surface (114);
disposing an encapsulant on the second surface (114) of the substrate (110), and solidifying into an encapsulation (150, 152) to encapsulate each of the radio-frequency integrated circuit modules (189) and the metal pillars (140); and
polishing the encapsulation (150, 152) until each of the heat conducting structures (160, 160b) and the second ends (144) of the corresponding metal pillars (140) are exposed from the encapsulation (150, 152), and a surface exposed by each of the heat conducting structures (160, 160b) is flush with the second ends (144) of the corresponding metal pillars (140).

2. The method (200, 200a, 300) of manufacturing the integrated antenna device (100, 100a, 100b) according to claim 1, wherein before the step of positioning the at least one radio-frequency integrated circuit module (189) to the second surface (114) of the substrate (110), the method (200, 200a, 300) further comprises:
providing a first vehicle (185) having a first adhesive layer (184), and disposing a first guide structure (186) above the first vehicle (185), and the first guide structure (186) comprises a plurality of first perforations (187);
allowing a plurality of heat conducting pillars (162) to extend into the first perforations (187) of the first guide structure (186), and allowing a plurality of third ends of the heat conducting pillars (162) to contact the first adhesive layer (184) and be fixed on the first vehicle (185);
disposing another encapsulant on the first vehicle (185), and solidifying into another encapsulation (150, 152) to encapsulate the heat conducting pillars (162);
allowing the third ends of the heat conducting pillars (162) that are encapsulated by the other encapsulation (150, 152) and a plurality of fourth ends opposite to the third ends to be exposed; and
allowing the third ends or the fourth ends that are exposed from the other encapsulation (150, 152) to be disposed above the fourth surface (134) of the radio-frequency integrated circuit (130) and thermally coupled to the radio-frequency integrated circuit (130).

3. The method (200, 200a, 300) of manufacturing the integrated antenna device (100, 100a, 100b) according to claim 1, wherein before the step of positioning the at least one set of metal pillars (140) to the second surface (114) of the substrate (110), the method (200, 200a, 300) further comprises:
providing a mask (191) fixed on a second adhesive layer (190), and disposing a second guide structure (193) above the mask (191), wherein the mask (191) comprises a plurality of second perforations (192), the second guide structure (193) comprises a plurality of third perforations (194), and the third perforations (194) are positioned to the second perforations (192);
allowing the metal pillars (140) to extend into the third perforations (194) of the second guide structure (193) and the second perforations (192) of the mask (191), and allowing the first ends (142) of the metal pillars (140) to be fixed on the second adhesive layer (190);
moving the metal pillars (140) next to a second vehicle (195) having a third adhesive layer (196), and allowing the second ends (144) of the metal pillars (140) to contact the third adhesive layer (196) to allow the metal pillars (140) to be fixed on the second vehicle (195); and
separating the second adhesive layer (190) from the metal pillars (140), and allowing the metal pillars (140) fixed on the second vehicle (195) to expose the first ends (142).

4. The method (200, 200a, 300) of manufacturing the integrated antenna device (100, 100a, 100b) according to claim 3, wherein after the step of separating the second adhesive layer (190) from the metal pillars (140), the method (200, 200a, 300) further comprises:
fixing the heat conducting structure (160, 160b) of the radio-frequency integrated circuit module (189) on the second vehicle (195), and allowing the heat conducting structure (160, 160b) to be positioned between the radio-frequency integrated circuit (130) and the second vehicle (195), the radio-frequency integrated circuit module (189) is surrounded by the metal pillars (140), and the third surface (132) of the radio-frequency integrated circuit (130) is flush with the first ends (142) of the metal pillars (140).

5. The method (200, 200a, 300) of manufacturing the integrated antenna device (100, 100a, 100b) according to claim 2, wherein after the step of allowing the third ends or the fourth ends of the heat conducting pillars (162) to be disposed above the fourth surface (134) of the radio-frequency integrated circuit (130), and before positioning the radio-frequency integrated circuit module (189) to the second surface (114) of the substrate (110), the method (200, 200a, 300) further comprises:
fixing the heat conducting structure (160, 160b) of each of the radio-frequency integrated circuit modules (189) on a third vehicle (197) having a fourth adhesive layer (198), and allowing the heat conducting structure (160, 160b) to be positioned between the radio-frequency integrated circuit (130) and the third vehicle (197).

6. The method (200, 200a, 300) of manufacturing the integrated antenna device (100, 100a, 100b) according to claim 1, wherein the step of positioning the at least one radio-frequency integrated circuit module (189) to the second surface (114) of the substrate (110) and the step of positioning the at least one set of metal pillars (140) to the second surface (114) of the substrate (110) are executed at a same time.
